# EUROPÄISCHE PATENTSCHRIFT

(11) **EP 2 220 693 B1**
(45) Veröffentlichungstag und Bekanntmachung des Hinweises auf die Patenterteilung: **08.02.2017**
(21) Anmeldenummer: 08861374.0
(22) Anmeldetag: 03.12.2008
(51) Int. Cl.: H01L 27/15, H01L 25/075

(54) **STRAHLUNGSEMITTIERENDE VORRICHTUNG**
RADIATION -EMITTING DEVICE
DISPOSITIF ÉMETTEUR DE RAYONNEMENT

(30) Priorität: 14.12.2007 DE 102007060257; 07.03.2008 DE 102008013030
(43) Veröffentlichungstag der Anmeldung: 25.08.2010
(73) Patentinhaber: OSRAM Opto Semiconductors GmbH, 93055 Regensburg (DE)
(72) Erfinder: HERRMANN, Siegfried, 94362 Neukirchen (DE)
(74) Vertreter: Epping - Hermann - Fischer
(86) Internationale Anmeldenummer: PCT/DE2008/002026
(87) Internationale Veröffentlichungsnummer: WO 2009/076933

(56) Entgegenhaltungen:
- EP-A- 1 953 837
- WO-A-97/23912
- DE-A1-102004 004 765
- DE-A1-102006 039 369
- DE-A1-102007 004 304

## Beschreibung

Die vorliegende Erfindung betrifft eine strahlungsemittierende Vorrichtung, die mindestens zwei zur Emission elektromagnetischer Strahlung ausgebildete aktive Halbleiterschichten aufweist.

Die DE 10 2006 039 369 A1 offenbart einen Halbleiterkörper mit einer ersten Strahlung erzeugenden aktiven Schicht und mit einer zweiten Strahlung erzeugenden aktiven Schicht, wobei die erste und die zweite aktive Schicht in vertikaler Richtung übereinander angeordnet und elektrisch in Serie geschaltet sind.

In der Druckschrift WO 97/23912 A2 ist eine mehrfarbiges Licht emittierende Diode und ein Herstellungsverfahren hierfür angegeben.

Aus der Druckschrift GB 2 366 074 A ist eine Lichtquelle mit zwei vertikal übereinander gestapelten LEDs mit unterschiedlichen Emissionswellenlängen bekannt.

Eine Leuchtdiode mit übereinander gestapelten Leuchtdiodenchips ist in der Druckschrift DE 20 2005 011 804 U1 beschrieben.

Die Aufgabe der Erfindung ist es, eine strahlungsemittierende Vorrichtung zu schaffen, mit der in einfacher Weise eine hohe Strahlungsdichte der emittierten elektromagnetischen Strahlung ermöglicht ist.

Die Aufgabe wird gelöst durch die Merkmale des unabhängigen Patentanspruchs. Vorteilhafte Ausgestaltungen der Erfindung sind in den abhängigen Ansprüchen gekennzeichnet.

Die Erfindung zeichnet sich aus durch eine strahlungsemittierende Vorrichtung, die aufweist eine erste aktive Halbleiterschicht, die zur Emission elektromagnetischer Strahlung und zum direkten Kontakt mit Anschlusselektroden ausgebildet ist, und mindestens eine weitere aktive Halbleiterschicht, die zur Emission elektromagnetischer Strahlung und zum direkten Kontakt mit Anschlusselektroden ausgebildet ist, wobei die erste aktive Halbleiterschicht und die weitere aktive Halbleiterschicht übereinander gestapelt angeordnet sind. Die strahlungsemittierende Vorrichtung hat also insbesondere einzeln ausgebildete aktive Halbleiterschichten, die auch als Halbleiterchips bezeichnet werden, oder miteinander gekoppelte aktive Halbleiterschichten, die zusammen einen Schichtstapel bilden. Die direkte Kontaktierung der aktiven Halbleiterschichten mit Anschlusselektroden ermöglicht eine Ausbildung der strahlungsemittierenden Vorrichtung aus substratlosen Halbleiterchips. Die zu stapelnden aktiven Halbleiterschichten sind separat voneinander gefertigt.

Dies hat den Vorteil, dass eine hohe Strahlungsdichte und eine sehr effiziente Lichtauskopplung bei hoher Wirtschaftlichkeit erreicht werden kann.

In einer vorteilhaften Ausführungsform umfassen die aktiven Halbleiterschichten wenigstens einen pn-Übergang oder sind durch einen solchen gebildet. Wenigstens eine Strahlung erzeugende Schicht der aktiven Halbleiterschichten ist dann insbesondere durch eine Ladungsträgerrekombinationszone zwischen einer p-dotierten Schicht und einer n-dotierten Schicht gebildet. Insbesondere ist genau eine Ladungsträgerkombinationszone zwischen genau einer p- und genau einer n-dotierten Schicht gebildet. Solche aktiven Halbleiterschichten können so ausgeformt sein, wie in der Druckschrift DE 10 2007 004 304 A1 beschrieben.

Unter der mindestens einen aktiven Halbleiterschicht kann auch eine Halbleiterschichtenfolge verstanden werden. Neben der aktiven Halbleiterschicht kann die Halbleiterschichtenfolge weitere funktionale Schichten wie Elektrodenschichten, Tunnelschichten, Kontaktschichten, Gitteranpassungsschichten, Wellenleiterschichten, Mantelschichten, Ladungsträgertransportschichten und/oder Ladungsträgerblockierschichten aufweisen. Die aktive Halbleiterschicht kann in diesem Fall auch Quantentröge umfassen oder durch solche gebildet sein. Beispielsweise ist die Halbleiterschichtenfolge ausgeformt, wie in der Druckschrift WO 2005/081319 A1 beschrieben. Im Folgenden wird ausschließlich der Begriff "aktive Halbleiterschicht" verwendet, auch wenn darunter eine Halbleiterschichtenfolge mit mehr als einer Schicht verstanden werden kann.

In einer weiteren vorteilhaften Ausführungsform besteht die wenigstens eine aktive Halbleiterschicht aus genau einer p-dotierten und genau einer n-dotierten Schicht, an deren Grenzfläche ein pn-Übergang gebildet ist, der die Strahlung erzeugende Schicht darstellt. Es ist optional möglich, dass die aktive Halbleiterschicht zusätzlich insbesondere genau eine oder genau zwei metallische Schichten oder Reflexionsschichten umfasst. Über diese metallischen oder Reflexionsschichten ist es beispielsweise möglich, mehrere aktive Halbleiterschichten miteinander zu verbinden und übereinander zu stapeln. Dies gilt insbesondere, falls die zu stapelnden aktiven Halbleiterschichten separat voneinander gefertigt sind.

In einer weiteren vorteilhaften Ausführungsform ist die strahlungemittierende Vorrichtung und/oder die zumindest eine aktive Halbleiterschicht für wenigstens einen Teil der erzeugten Strahlung transparent oder halbtransparent. Mit anderen Worten beträgt der Anteil der in der aktiven Halbleiterschicht und/oder in der strahlungemittierenden Vorrichtung erzeugten und gestreuten oder absorbierten Strahlung weniger als 50 %, insbesondere weniger als 20 %, bevorzugt weniger als 10 %.

In einer Abwandlung sind die erste aktive Halbleiterschicht und die weitere aktive Halbleiterschicht in einem gemeinsamen Halbleiterkörper ausgebildet. Dies bedeutet, dass die erste aktive Halbleiterschicht und die weitere aktive Halbleiterschicht miteinander monolithisch ausgebildet sind, zum Beispiel über ein epitaktisches Wachsen. Mit anderen Worten werden die aktiven Halbleiterschichten nicht separat voneinander gefertigt und anschließen zum Beispiel geklebt, gebondet oder gelötet. Dies ermöglicht eine einfache Herstellung der strahlungsemittierenden Vorrichtung.

In einer weiteren vorteilhaften Ausführungsform ist die erste aktive Halbleiterschicht und/oder die weitere aktive Halbleiterschicht thermisch mit einer Wärme abführenden Schicht gekoppelt. Dies stellt eine einfache Möglichkeit einer guten Ableitung von thermischer Energie von der ersten oder der weiteren aktiven Halbleiterschicht an die Umgebung dar.

In einer weiteren vorteilhaften Ausführungsform sind die erste aktive Halbleiterschicht und/oder die weitere aktive Halbleiterschicht mechanisch fest mit der Wärme abführenden Schicht gekoppelt.

In einer weiteren vorteilhaften Ausführungsform emittieren die erste aktive Halbleiterschicht und die weitere aktive Halbleiterschicht Strahlung gleicher Wellenlänge. Es ist so möglich, eine besonders hohe Leuchtdichte in einem Spektralbereich zu erreichen.

In einer weiteren vorteilhaften Ausführungsform emittieren die erste aktive Halbleiterschicht und die weitere aktive Halbleiterschicht Strahlung unterschiedlicher Wellenlänge. Damit kann auf effiziente Weise Licht einer Mischfarbe oder Weißlicht erzeugt werden.

In einer weiteren vorteilhaften Ausführungsform weist die erste aktive Halbleiterschicht eine Strahlungsauskopplungsfläche und eine auf einer der Strahlungsauskopplungsfläche abgewandten Seite der ersten aktiven Halbleiterschicht angeordnete Reflexionsschicht auf. Dies hat den Vorteil, dass die gesamte Strahlung so gerichtet werden kann, dass diese gezielt auf einer Seite der strahlungsemittierenden Vorrichtung abgestrahlt wird.

In einer weiteren vorteilhaften Ausführungsform ist die Reflexionsschicht thermisch mit der Wärme abführenden Schicht gekoppelt. Dies hat den Vorteil, dass eine einfache und besonders zuverlässige und effiziente thermische Kopplung zwischen der ersten aktiven Halbleiterschicht und der Wärme abführenden Schicht möglich ist.

In einer weiteren vorteilhaften Ausführungsform sind zwischen den aktiven Halbleiterschichten eine oder mehrere weitere Reflexionsschichten angeordnet. Die weiteren Reflexionsschichten weisen vorzugsweise einen Brechungsindex auf, der zwischen den Brechungsindizes der aktiven Halbleiterschichten und der Umgebung liegt.

Durch die weitere Reflexionsschicht wird der Sprung im Brechungsindex zwischen der aktiven Halbleiterschicht und ihrer Umgebung jeweils in zwei kleinere Sprünge aufgeteilt. Auf diese Weise kann ein größerer Anteil der Strahlung aus der aktiven Halbleiterschicht austreten und in die weitere Reflexionsschicht eintreten. Dieser Teil der Strahlung kann entweder weitere aktive Halbleiterschichten passieren oder direkt durch einen Auskoppelbereich in die Umgebung emittiert werden. Auf Grund des geringeren Unterschiedes im Brechungsindex zwischen der weitere Reflexionsschicht und der Umgebung kann ein größerer Teil der Strahlung ausgekoppelt werden.

In einer weiteren vorteilhaften Ausführungsform ist die Reflexionsschicht elektrisch leitend ausgebildet. Die Reflexionsschicht ist dann zum Beispiel eine dünne Metallschicht oder eine Schicht eines transparenten, elektrisch leitenden Materials. Im Falle einer Metallschicht beträgt deren Dicke, in einer Richtung senkrecht zu einer Hauptseite der aktiven Halbleiterschicht, bevorzugt höchstens 30 nm, insbesondere höchstens 10 nm. Damit kann die Reflexionsschicht in einfacher Weise auch als Anschlusselektrode ausgebildet sein. Auch kann über die Reflexionsschicht eine Stromverteilung und eine gleichmäßig Stromeinprägung über die gesamte Fläche der aktiven Halbleiterschicht erfolgen. Insbesondere erstreckt sich die Reflexionsschicht mindestens über eine gesamte laterale Ausdehnung der aktiven Halbleiterschicht, wobei gegebenenfalls vorhandene, von der Reflexionsschicht verschiedene Anschlusselektroden in diesem Fall als zu der Reflexionsschicht gehörig zu zählen sind.

In einer weiteren vorteilhaften Ausführungsform überragen die meisten oder alle Anschlusselektroden die aktiven Halbleiterschichten in einer lateralen Richtung. Bevorzugt überlappen sich die Anschlusselektroden hierbei in einer Richtung parallel zu einer Stapelrichtung der aktiven Halbleiterschichten nicht oder nicht vollständig. Hierdurch ist eine elektrische Kontaktierung der aktiven Halbleiterschichten erleichtert.

In einer weiteren vorteilhaften Ausführungsform weist die weitere aktive Halbleiterschicht eine erste Strahlungsauskopplungsfläche und eine auf einer der ersten Strahlungsauskopplungsfläche der weiteren aktiven Halbleiterschicht abgewandten Seite angeordnete weitere Strahlungsauskopplungsfläche auf. Damit sind doppelseitig strahlungsemittierende aktive Halbleiterschichten und damit auch doppelseitig strahlungsemittierende Vorrichtungen möglich.

In einer weiteren vorteilhaften Ausführungsform ist eine der Strahlungsauskopplungsflächen der weiteren aktiven Halbleiterschicht der Strahlungsauskopplungsfläche der ersten aktiven Halbleiterschicht zugewandt. Dies hat den Vorteil, dass die Erzeugung von mischfarbigen Licht oder Weißlicht bei hoher Leuchtdichte sowohl einseitig als auch doppelseitig emittierend möglich ist.

In einer weiteren vorteilhaften Ausführungsform hat die aktive Halbleiterschicht eine Dicke zwischen 3 µm und 20 µm. Dies hat den Vorteil, dass eine sehr dünne Ausbildung der aktiven Halbleiterschichten und damit der gesamten strahlungsemittierenden Vorrichtung möglich ist.

In einer weiteren vorteilhaften Ausführungsform haben die übereinander gestapelten aktiven Halbleiterschichten zusammen eine Gesamtdicke zwischen 6 µm und 30 µm. Dies hat den Vorteil, dass eine sehr dünne Ausbildung der gesamten strahlungsemittierenden Vorrichtung möglich ist.

In einer weiteren vorteilhaften Ausführungsform ist die strahlungsemittierende Vorrichtung als Leuchtdiode ausgebildet. Es ist so möglich, substratlose strahlungsemittierende Vorrichtungen mit mehreren übereinander angeordneten aktiven Halbleiterschichten für Leuchtdioden einzusetzen.

In einer weiteren vorteilhaften Ausführungsform ist die strahlungsemittierende Vorrichtung flächenförmig ausgebildet. Dabei kann flächenförmig ausgebildet bedeuten, dass sich die strahlungsemittierende Vorrichtung zusammenhängend über einen Flächenbereich erstreckt, der zumindest eine Fläche von mehreren Quadratmillimetern, bevorzugt mehreren Quadratzentimetern und besonders bevorzugt zumindest einem oder mehreren Quadratdezimetern oder mehr aufweist. Beispielsweise umfasst dieser strahlungemittierende Flächenbereich mindestens 1 mm², insbesondere mindestens 10 mm², bevorzugt mindestens 1 cm², speziell mindestens 5 cm². Damit ist es möglich, sehr flache, flächenförmig ausgebildete substratlose strahlungsemittierende Vorrichtungen mit mehreren aktiven Halbleiterschichten zu erhalten.

In einer weiteren vorteilhaften Ausführungsform hat die strahlungsemittierende Vorrichtung die erste aktive Halbleiterschicht und mindestens zwei weitere aktive Halbleiterschichten, wobei mindestens eine der aktiven Halbleiterschichten zur Emission elektromagnetischer Strahlung im roten Spektralbereich, mindestens eine der aktiven Halbleiterschichten zur Emission elektromagnetischer Strahlung im grünen Spektralbereich und mindestens eine der aktiven Halbleiterschichten zur Emission elektromagnetischer Strahlung im blauen Spektralbereich ausgebildet ist. Damit kann mittels der strahlungsemittierenden Vorrichtung Licht beliebiger Farbe sowie Weißlicht erzeugt werden.

In einer weiteren vorteilhaften Ausführungsform sind laterale Abmessungen aller aktiven Halbleiterschichten, im Rahmen der Herstellungstoleranzen, gleich. Mit anderen sind die aktiven Halbleiterschichten deckungsgleich übereinander gestapelt. Bevorzugt stehen einander benachbarte aktive Halbleiterschichten in direktem Kontakt zu einander, insbesondere über deren gesamte, einander zugewandte Hauptflächen. Das heißt, über die gesamten Hauptflächen berühren sich die aktiven Halbleiterschichten in diesem Fall.

In einer weiteren vorteilhaften Ausführungsform sind die aktiven Halbleiterschichten jeweils unabhängig voneinander elektrisch ansteuerbar. Zum Beispiel sind die aktiven Halbleiterschichten in Form einer elektrischen Parallelschaltung verschaltet.

In einer weiteren vorteilhaften Ausführungsform sind die aktiven Halbleiterschichten elektrisch voneinander isoliert. Zum Beispiel ist die Reflexionsschicht mit einem dielektrischen Material gestaltet. Elektrisch isoliert bedeutet, dass kein direkter elektrischer Kontakt zwischen insbesondere benachbarten aktiven Halbleiterschichten innerhalb des Halbleiterkörpers vorliegt.

In einer weiteren vorteilhaften Ausführungsform ist die strahlungemittierende Vorrichtung frei von einem Konversionsmittel. Mit anderen Worten umfasst die Vorrichtung keinen Phosphor oder Leuchtstoff, eine von der aktiven Halbleiterschicht emittierte Strahlung ein eine Strahlung einer anderen Frequenz konvertiert.

Vorzugsweise wird die strahlungsemittierende Vorrichtung für Beleuchtungszwecke verwendet. Dies hat den Vorteil, dass damit eine kompakte, Platz sparende, farbige, gegebenenfalls doppelseitige Beleuchtung in flacher Bauform realisierbar ist, die eine hohe Strahlungsdichte und einen hohen energetischen Wirkungsgrad hat.

Vorzugsweise wird die strahlungsemittierende Vorrichtung für monochrome oder mehrfarbige Elektrolumineszenzanzeigen verwendet. Dies hat den Vorteil, dass damit eine kompakte, Platz sparende, farbige Anzeige in flacher Bauform mit hoher Strahlungsdichte und einem hohen energetischen Wirkungsgrad realisierbar ist.

Vorzugsweise wird die strahlungsemittierende Vorrichtung für Projektionsanwendungen verwendet. Dies hat den Vorteil, dass damit ein kompakter, Platz sparender, farbiger Projektor realisierbar ist.

Vorteilhafte Ausgestaltungen der Erfindung sind nachfolgend anhand der schematischen Zeichnungen näher erläutert.

Es zeigen:
- Figur 1: eine Schnittansicht einer ersten Ausführungsform einer strahlungsemittierenden Vorrichtung, und
- Figur 2: eine Schnittansicht einer weiteren Ausführungsform der strahlungsemittierenden Vorrichtung.

Elemente gleicher Konstruktion oder Funktion sind figurenübergreifend mit den gleichen Bezugszeichen gekennzeichnet. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche zur besseren Darstellbarkeit und/oder zum besseren Verständnis übertrieben dick oder groß dimensioniert dargestellt sein.

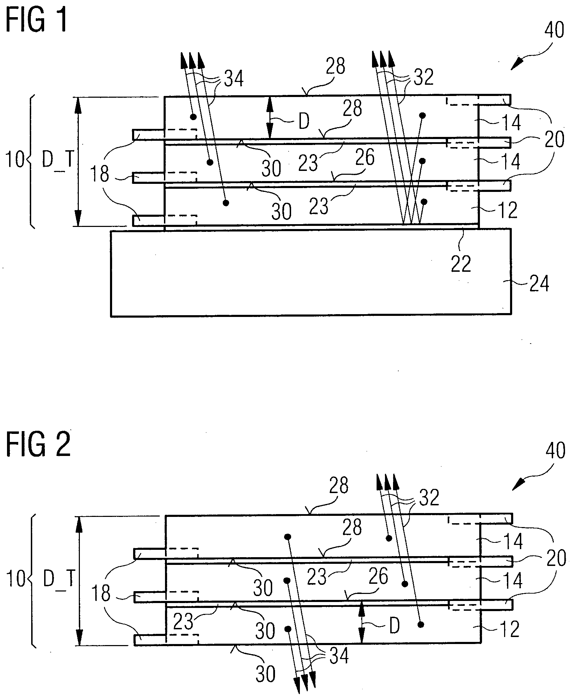

In den Figuren 1 und 2 sind jeweils Ausführungsbeispiele für eine strahlungsemittierende Vorrichtung 40 gezeigt.

In Figur 1 ist eine erste Ausführungsform für eine strahlungsemittierende Vorrichtung 40 gezeigt. Die strahlungsemittierende Vorrichtung 40 weist einen Halbleiterkörper 10 auf. Der Halbleiterkörper 10 hat eine zur Emission elektromagnetischer Strahlung ausgebildete erste aktive Halbleiterschicht 12 und weitere zur Emission elektromagnetischer Strahlung ausgebildete aktive Halbleiterschichten 14. Die in den Figuren gezeigten Ausführungsformen der strahlungsemittierenden Vorrichtung 40 weisen jeweils zwei weitere zur Emission elektromagnetischer Strahlung ausgebildete aktive Halbleiterschichten 14 auf. Die Zahl der weiteren aktiven Halbleiterschichten 14 der strahlungsemittierenden Vorrichtung 40 kann jedoch auch einen beliebigen anderen Wert annehmen.

Für die aktiven Halbleiterschichten 12, 14 eignen sich Halbleitermaterialien, wie beispielsweise InAlGaAs, InGaAlP und/oder InGaAlN, wobei die jeweiligen binären und ternären Verbindungen, wie zum Beispiel GaAs, AlGaAs, GaP, InP, GaAlP, GaN oder InGaN, eingeschlossen sind. Dabei muss das jeweilige Material nicht zwingend einer mathematisch exakten Zusammensetzung entsprechen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber sind jedoch nur die wesentlichen Bestandteile des Kristallgitters (Al, Ga, In, P) genannt, auch wenn diese teilweise durch geringe Mengen weiterer Stoffe ersetzt sein können.

Die aktiven Halbleiterschichten 12, 14 der strahlungsemittierenden Vorrichtung 40 weisen bevorzugt Anordnungen und Strukturierungen der Materialien auf, die dem Fachmann bekannt sind und daher an dieser Stelle nicht weiter ausgeführt werden. In den aktiven Halbleiterschichten 12, 14 kann durch Elektronen- und Löcherrekombination elektromagnetische Strahlung mit einer einzelnen Wellenlänge oder einem Bereich von Wellenlängen erzeugt werden. Dabei kann bei einem Betrachter ein einfarbiger, ein mehrfarbiger und/oder ein mischfarbiger Leuchteindruck entstehen.

Die von den aktiven Halbleiterschichten 12, 14 der strahlungsemittierenden Vorrichtung 40 erzeugte elektromagnetische Strahlung kann insbesondere ein Spektrum mit Wellenlängen in einem ultravioletten bis infraroten Spektralbereich aufweisen. Insbesondere kann es vorteilhaft sein, wenn das Spektrum zumindest eine für einen Betrachter sichtbare Wellenlänge umfasst. Das Spektrum der elektromagnetischen Strahlung kann vorteilhafterweise auch mehrere Wellenlängen umfassen, so dass bei einem Betrachter ein mischfarbiger Leuchteindruck entstehen kann. Dazu kann es möglich sein, dass die strahlungsemittierende Vorrichtung 40 selbst elektromagnetische Strahlung mit mehreren Wellenlängen erzeugen kann.

Die gezeigten strahlungsemittierenden Vorrichtungen 40 sind bevorzugt als eine Leuchtdiode oder ein Leuchtdiodenarray ausgebildet. Bevorzugt ist die strahlungsemittierende Vorrichtung 40 flächenförmig ausgebildet.

Die erste aktiven Halbleiterschicht 12 und die weiteren aktiven Halbleiterschichten 14 sind als Schichtenstapel übereinander angeordnet. Die aktiven Halbleiterschichten 12, 14, insbesondere die erste aktive Halbleiterschicht 12, sind dabei als substratlose Schichten ausgebildet. Substratlos heißt hier, dass eine ansonsten vorhandene Träger- oder Substratschicht der beispielsweise als Leuchtdiode ausgebildeten strahlungsemittierenden Vorrichtung 40 entfällt. Durch die Anordnung der ersten aktiven Halbleiterschicht 12 und der weiteren aktiven Halbleiterschichten 14 gestapelt übereinander kann vorteilhafterweise die gesamte erzeugte Strahlungsmenge sehr hoch sein. Da sich die Abmessungen der strahlungsemittierenden Vorrichtung 40 gegenüber einer einzigen aktiven Halbleiterschicht nur unmaßgeblich ändern und insbesondere der Querschnitt der strahlungsemittierenden Vorrichtung 40 von der Zahl der aktiven Halbleiterschichten 12, 14 unabhängig ist, kann so weitgehend auch die Strahlungsdichte vorteilhaft hoch sein.

Vorzugsweise emittiert der Halbleiterkörper 10 im Betrieb Strahlung in vertikaler Richtung, wobei die von der ersten aktiven Halbleiterschicht 12 und den weiteren aktiven Halbleiterschichten 14 emittierten Strahlungsanteile typischerweise gemischt sind.

Die aktiven Halbleiterschichten 12, 14 weisen vorzugsweise eine Dicke D zwischen 3 µm und 20 µm auf. Besonders bevorzugt ist die Dicke D der aktiven Halbleiterschichten 12, 14 zwischen 12 µm und 15 µm. Derartig dünne aktive Halbleiterschichten 12, 14 lassen sich einerseits noch gut herstellen, andererseits kann die strahlungsemittierende Vorrichtung 40 sehr dünn ausgebildet sein. Besonders bevorzugt ist, wenn die übereinander gestapelten aktiven Halbleiterschichten 12, 14 zusammen eine Gesamtdicke D_T zwischen 6 µm und 30 µm haben.

Jede der aktiven Halbleiterschichten 12, 14 hat Anschlusselektroden 18, 20, die eine direkte elektrische Kontaktierung der aktiven Halbleiterschichten 12, 14 ermöglicht. Eine elektrische Kontaktierung der als Leuchtdiode ausgebildeten strahlungsemittierenden Vorrichtung 40 über die ansonsten vorhandene Träger- oder Substratschicht kann hier vermieden werden. Insbesondere können die Anschlusselektroden 18, 20 flächig oder in Teilbereichen strukturiert ausgeführt sein.

Die Anschlusselektroden 18, 20 sind bevorzugt als elektrisch leitendes Oxid ausgebildet. Besonders bevorzugt ist die Ausbildung der Anschlusselektroden 18, 20 als transparentes elektrisch leitendes Oxid (Transparent Conductive Oxid, TCO).

Transparente elektrisch leitende Oxide sind transparente leitende Materialien, in der Regel Metalloxide, wie beispielsweise Zinkoxid, Zinnoxid, Cadmiumoxid, Titanoxid, Indiumoxid oder besonders bevorzugt Indium-Zinnoxid (ITO). Neben binären Metall-Sauerstoffverbindungen, wie beispielsweise ZnO, SnO₂ oder In₂O₃ gehören auch ternäre Metall-SauerstoffVerbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter elektrisch leitender Oxide zu der Gruppe der transparenten elektrisch leitenden Oxide. Weiterhin müssen die transparenten elektrisch leitenden Oxide nicht zwingend einer stöchiometrischen Zusammensetzung entsprechen und können auch p- oder n-dotiert sein.

Als Material für die Anschlusselektroden können insbesondere auch Metalle wie Aluminium, Barium, Indium, Silber, Gold, Magnesium, Kalzium oder Lithium sowie Verbindungen, Kombinationen und Legierungen davon vorteilhaft sein.

Die bezüglich der Figuren jeweils unterhalb der aktiven Halbleiterschichten 12, 14 angeordneten Anschlusselektroden 18 sind bevorzugt als Anoden ausgeführt, womit sie als Löcher induzierende Elemente dienen können.

Die bezüglich der Figuren jeweils oberhalb der aktiven Halbleiterschichten 12, 14 angeordneten Anschlusselektroden 20 sind bevorzugt als Kathode ausgeführt und dienen somit als Elektronen induzierende Elemente.

In der in Figur 1 gezeigten ersten Ausführungsform der strahlungsemittierenden Vorrichtung 40 ist auf einer von den weiteren aktiven Halbleiterschichten 14 abgewandten Seite der ersten aktiven Halbleiterschicht 12 eine Reflexionsschicht 22 angeordnet. Die Reflexionsschicht 22 kann beispielsweise als metallische Reflexionsschicht oder als dielektrische Reflexionsschicht ausgeführt sein. Mittels eines dielektrischen Materials wird die Reflexion der auftreffenden Strahlung aufgrund eines Sprunges im Brechungsindex erreicht. Eine dielektrische Reflexionsschicht kann auch als Bragg-Spiegel ausgeführt sein.

Besonders bevorzugt ist, wenn die Reflexionsschicht 22 elektrisch leitend ausgebildet ist, da es dann einfach möglich ist, die Reflexionsschicht 22 als Anschlusselektrode für die erste aktive Halbleiterschicht 12 zu verwenden.

Die Reflexionsschicht 22 ist mechanisch und thermisch mit einer Wärme abführenden Schicht 24 gekoppelt. Diese dient zum einen dazu, eine feste mechanische Kopplung zwischen den aktiven Halbleiterschichten 12, 14 und der Wärme abführenden Schicht 24 zu ermöglichen. Zum anderen dient sie dazu, Wärme, die in einer der aktiven Halbleiterschichten 12, 14 entsteht, aufzunehmen und an die Umgebung abzugeben. Eine Überhitzung der aktiven Halbleiterschichten 12, 14 kann so vermieden werden. Besonders bevorzugt hat die Wärme abführende Schicht 24 eine größere laterale Ausdehnung als die aktiven Halbleiterschichten 12, 14, um so die mechanischen und thermischen Anforderungen gut erfüllen zu können. Die Wärme abführende Schicht 24 ist bevorzugt aus einem Material gebildet, das AlN aufweist.

Zwischen zwei Halbleiterschichten 12, 14 ist eine weitere Reflexionsschicht 23 angeordnet ist.

Die weitere Reflexionsschicht 23 weist vorzugsweise einen Brechungsindex auf, der zwischen dem Brechungsindex der Halbleiterschichten 12, 14 und ihrer Umgebung liegt. Die weitere Reflexionsschicht 23 ist für die erzeugte Strahlung transparent. Ein geeignetes Material ist beispielsweise Siliziumdioxid.

Die weitere Reflexionsschicht 23 bewirkt zum Einen, dass Strahlung, die aus einer Halbleiterschicht 12, 14 kommt, zu einem größeren Anteil diese Halbleiterschicht 12, 14 verlassen kann und in die weitere Reflexionsschicht 23 eindringen kann. Aus dieser weiteren Reflexionsschicht 23 kann sie entweder in eine weitere Halbleiterschicht 12, 14 eintreten und später die strahlungsemittierende Vorrichtung 40 durch eine Strahlungsauskopplungsfläche verlassen, wie im folgenden beschrieben wird. Die Auskoppeleffizienz wird mittels der weiteren Reflexionsschicht 23 erhöht.

Die erste aktive Halbleiterschicht 12 weist eine Strahlungsauskopplungsfläche 26 auf. Die weiteren aktiven Halbleiterschichten 14 weisen jeweils eine erste Strahlungsauskopplungsfläche 28 und eine auf einer der ersten Strahlungsauskopplungsfläche 28 der weiteren aktiven Halbleiterschicht 14 abgewandten Seite angeordnete weitere Strahlungsauskopplungsfläche 30 auf.

Die Funktion der Ausführungsform der strahlungsemittierenden Vorrichtung 40 der Figur 1 wird im Folgenden kurz dargestellt:
Erste elektromagnetische Strahlungsanteile 32 werden in den aktiven Halbleiterschichten 12, 14 erzeugt und in Richtung der Wärme abführenden Schicht 24 abgestrahlt, an der Reflexionsschicht 22 reflektiert und treten dann über die Strahlungsauskopplungsfläche 26 der ersten aktiven Halbleiterschicht 12 und die Strahlungsauskopplungsflächen 28 der weiteren aktiven Halbleiterschichten 14 aus der strahlungsemittierenden Vorrichtung 40 aus. Die aktiven Halbleiterschichten 12, 14 sind so ausgebildet, dass sie für die elektromagnetischen Strahlungsanteile 32 aus den benachbarten aktiven Halbleiterschichten 12, 14 jeweils transparent sind.

Des Weiteren tritt ein in den aktiven Halbleiterschichten 12, 14 erzeugter zweiter elektromagnetischer Strahlungsanteil 34 direkt über die Strahlungsauskopplungsfläche 26 der ersten aktiven Halbleiterschicht 12 und die Strahlungsauskopplungsflächen 28 der weiteren aktiven Halbleiterschichten 14 aus der strahlungsemittierenden Vorrichtung 40 aus.

Damit ist die substratlose strahlungsemittierende Vorrichtung 40 der Ausführungsform der Figur 1, die aus aktiven Halbleiterschichten 12, 14 aufgebaut ist, einseitig emittierend ausgebildet.

In der in Figur 2 dargestellten Ausführungsform sind die aktiven Halbleiterschichten 12, 14 ebenfalls ohne Trägerschicht, also substratlos, aufgebaut und als einzelne, separate Halbleiterchips ausgebildet. Es ist also möglich, durch eine beliebige Kombination von einzelnen als substratlosen Halbleiterchips ausgebildeten, aktiven Halbleiterschichten 12, 14, die als Schichtstapel übereinander angeordnet sind, jeweils eine in geeigneter Weise angepasste strahlungsemittierende Vorrichtung 40 aufzubauen.

In der in Figur 2 gezeigten Ausführungsform der strahlungsemittierenden Vorrichtung 40 kann jede der aktiven Halbleiterschichten 12, 14 jeweils über zwei Strahlungsauskopplungsflächen 26, 28, 30 Strahlung im Wesentlichen in zwei Richtungen emittieren.

Die ersten elektromagnetischen Strahlungsanteile 32 werden in den aktiven Halbleiterschichten 12, 14 erzeugt und treten dann über die Strahlungsauskopplungsfläche 26 der ersten aktiven Halbleiterschicht 12 und die ersten Strahlungsauskopplungsflächen 28 der weiteren aktiven Halbleiterschichten 14 aus der strahlungsemittierenden Vorrichtung 40 aus.

Des Weiteren werden die zweiten elektromagnetischen Strahlungsanteile 34 in den aktiven Halbleiterschichten 12, 14 erzeugt und treten dann über die weiteren Strahlungsauskopplungsflächen 30 der weiteren aktiven Halbleiterschichten 14 und die weitere Strahlungsauskopplungsfläche 30 der ersten aktiven Halbleiterschicht 12 aus der strahlungsemittierenden Vorrichtung 40 aus.

Dies bedeutet, dass die in der Figur 2 gezeigte substratlose strahlungsemittierende Vorrichtung 40 aus aktiven Halbleiterschichten 12, 14 doppelseitig emittierend ausgebildet ist. Wegen der Möglichkeit der beidseitigen Lichtauskopplung kann auf eine interne Verspiegelung der aktiven Halbleiterschichten 12, 14 verzichtet werden, und die Reflexionsschicht kann entfallen.

Emittieren die erste aktive Halbleiterschicht 12 und die weiteren aktiven Halbleiterschichten 14 Strahlung gleicher Wellenlänge, so kann damit eine besonders hohe Strahlungsdichte der strahlungsemittierenden Vorrichtung 40 ermöglicht werden.

Sind dagegen die erste aktive Halbleiterschicht 12 und die weiteren aktiven Halbleiterschichten 14 so ausgebildet, dass sie jeweils Strahlung unterschiedlicher Wellenlängen emittieren, so ist es mit der strahlungsemittierenden Vorrichtung 40 sehr einfach möglich, farbiges Mischlicht oder Weißlicht zu erzeugen.

Ist mindestens eine der aktiven Halbleiterschichten 12, 14 zur Emission elektromagnetischer Strahlung im roten Spektralbereich ausgebildet, eine weitere der aktiven Halbleiterschichten 12, 14 zur Emission elektromagnetischer Strahlung im grünen Spektralbereich und mindestens eine der weiteren aktiven Halbleiterschichten 12, 14 zur Emission elektromagnetischer Strahlung im blauen Spektralbereich ausgebildet, so lässt sich farbiges Mischlicht oder Weißlicht besonders einfach herstellen.

Die erste Strahlungsauskopplungsfläche 28 der äußeren weiteren aktiven Halbleiterschicht 14 kann zur verbesserten Auskopplung der Strahlung eine Aufrauung oder eine andere Struktur aufweisen, durch die die Totalreflexion an der Strahlungsauskopplungsfläche behindert wird. Dann kann die über die erste Strahlungsauskopplungsfläche 28 der äußeren weiteren aktiven Halbleiterschicht 14 ausgekoppelte Strahlungsleistung erhöht werden. Anstatt der Aufrauung kann auch eine Oberflächenstrukturierung etwa in Form von Mikroprismen oder anderen Mitteln zur Reduzierung von Totalreflexionsverlusten an der Strahlungsauskopplungsfläche vorgesehen sein.

Weiterhin kann die strahlungsemittierende Vorrichtung 40 optische Elemente aufweisen, die der äußeren weiteren aktiven Halbleiterschicht 14 in Abstrahlrichtung der elektromagnetischen Strahlung nachgeordnet sind. Insbesondere kann etwa auf der Außenseite der äußeren weiteren aktiven Halbleiterschicht 14 ein Zirkularpolarisator angeordnet sein, mit dem auf vorteilhafte Weise vermieden werden kann, dass Licht, das von außen in die strahlungsemittierende Vorrichtung 40 hineingestrahlt wird und das beispielsweise an den Anschlusselektroden 18, 20 reflektiert werden kann, wieder aus der strahlungsemittierenden Vorrichtung 40 austreten kann.

Die beschriebenen strahlungsemittierenden Vorrichtungen 40 können durch die schon geschilderten Vorteile einer hohen Strahlungsdichte und einen hohen Wirkungsgrad eine hohe Wirtschaftlichkeit ermöglichen.

Die gezeigten strahlungsemittierenden Vorrichtungen 40 können geeignet sein für eine Verwendung in Anzeige- und/oder Beleuchtungseinrichtungen, die sich durch eine kompakte, Platz sparende und flache Bauform auszeichnen.

Als Leuchtdioden ausgebildete substratlose strahlungsemittierende Vorrichtungen 40 mit mehreren übereinander angeordneten aktiven Halbleiterschichten 12, 14 werden insbesondere bevorzugt für Beleuchtungszwecke, im speziellen für die großflächige Beleuchtung, beispielsweise von Räumen, verwendet.

Ein weiteres Einsatzgebiet stellen Anzeigen für Automobile oder Mobiltelefone, Touchscreen-Displays und ähnliches dar. Diese Anzeigen sind bevorzugt als monochrome oder mehrfarbige Elektrolumineszenzanzeigen ausgebildet.

Darüber hinaus können als Leuchtdioden ausgebildete strahlungsemittierende Vorrichtungen 40 für Projektoren verwendet werden. Mit den hier beschriebenen strahlungsemittierenden Vorrichtungen 40 können derartige Projektoren sehr klein und kompakt gebaut sein.

## Patentansprüche

1. Strahlungsemittierende Vorrichtung (40), die aufweist
- eine erste aktive Halbleiterschicht (12), die zur Emission elektromagnetischer Strahlung einer ersten Wellenlänge und zum direkten Kontakt mit Anschlusselektroden (18, 20) ausgebildet ist, und
- eine weitere aktive Halbleiterschicht (14), die zur Emission elektromagnetischer Strahlung einer von der ersten verschiedenen zweiten Wellenlänge und zum direkten Kontakt mit Anschlusselektroden (18, 20) ausgebildet ist, wobei die erste aktive Halbleiterschicht (12) und die weitere aktive Halbleiterschicht (14) übereinander gestapelt angeordnet sind,
wobei die erste und die weitere aktive Halbleiterschicht (12, 14) separat voneinander gefertigt sind,
**dadurch gekennzeichnet, dass**
- die erste und die weitere aktive Halbleiterschicht (12, 14) substratlos ohne Trägerschicht aufgebaut und als einzelne, separate Halbleiterchips ausgebildet sind,
- zwischen den aktiven Halbleiterschichten (12, 14) eine erste Reflexionsschicht (23) angeordnet ist, die eine Schicht eines transparenten, elektrisch leitenden Materials ist,
- durch die erste Reflexionsschicht (23) ein Sprung im Brechungsindex zwischen den aktiven Halbleiterschichten (12, 14) in zwei kleinere Sprünge aufgeteilt ist,
- die erste aktive Halbleiterschicht (12) eine Strahlungsauskopplungsfläche (26) und eine auf einer der Strahlungsauskopplungsfläche (26) abgewandten Seite der ersten aktiven Halbleiterschicht (12) angeordnete zweite Reflexionsschicht (22) aufweist, und
- die zweite Reflexionsschicht (22) eine metallische oder dielektrische Schicht ist.

2. Strahlungsemittierende Vorrichtung (40) nach Anspruch 1, wobei die erste aktive Halbleiterschicht (12) und/oder die weitere aktive Halbleiterschicht (14) mechanisch fest und/oder thermisch mit einer Wärme abführenden Schicht (24) gekoppelt sind.

3. Strahlungsemittierende Vorrichtung (40) nach einem der vorhergehenden Ansprüche,
wobei die zweite Reflexionsschicht (22) thermisch mit der Wärme abführenden Schicht (24) gekoppelt ist.

4. Strahlungsemittierende Vorrichtung (40) nach einem der vorhergehenden Ansprüche,
wobei die weitere aktive Halbleiterschicht (14) eine erste Strahlungsauskopplungsfläche (28) und eine auf einer der ersten Strahlungsauskopplungsfläche (28) der weiteren aktiven Halbleiterschicht (14) abgewandten Seite angeordnete weitere Strahlungsauskopplungsfläche (30) aufweist.

5. Strahlungsemittierende Vorrichtung (40) nach dem vorhergehenden Anspruch,
wobei eine der Strahlungsauskopplungsflächen (28, 30) der weiteren aktiven Halbleiterschicht (14) der Strahlungsauskopplungsfläche (26) der ersten aktiven Halbleiterschicht (12) zugewandt ist.

6. Strahlungsemittierende Vorrichtung (40) nach einem der vorhergehenden Ansprüche,
wobei die aktive Halbleiterschicht (12, 14) eine Dicke (D) zwischen 3 µm und 20 µm hat.

7. Strahlungsemittierende Vorrichtung (40) nach einem der vorhergehenden Ansprüche,
wobei die übereinander gestapelten aktiven Halbleiterschichten (12, 14) zusammen eine Gesamtdicke (D_T) zwischen 6 µm und 30 µm haben.

8. Strahlungsemittierende Vorrichtung (40) nach einem der vorhergehenden Ansprüche,
wobei die strahlungsemittierende Vorrichtung (40) flächenförmig ausgebildet ist und ein strahlungsemittierender Flächenbereich eine Fläche von mindestens 10 mm² aufweist.

9. Strahlungsemittierende Vorrichtung (40) nach einem der vorhergehenden Ansprüche,
mit der ersten aktiven Halbleiterschicht (12) und mindestens zwei weiteren aktiven Halbleiterschichten (14), wobei mindestens eine der aktiven Halbleiterschichten (12, 14) zur Emission elektromagnetischer Strahlung im roten Spektralbereich, mindestens eine der aktiven Halbleiterschichten (12, 14) zur Emission elektromagnetischer Strahlung im grünen Spektralbereich und mindestens eine der aktiven Halbleiterschichten (12, 14) zur Emission elektromagnetischer Strahlung im blauen Spektralbereich ausgebildet ist.

10. Verwendung einer strahlungsemittierenden Vorrichtung (40) nach einem der vorhergehenden Ansprüche für Beleuchtungszwecke und/oder für monochrome oder mehrfarbige Elektrolumineszenzanzeigen und/oder für Projektionsanwendungen.

## Claims

1. Radiation-emitting device (40) comprising
- a first active semiconductor layer (12) embodied for the emission of electromagnetic radiation of a first wavelength and for direct contact with connection electrodes (18, 20), and
- a further active semiconductor layer (14) embodied for the emission of electromagnetic radiation of a second wavelength which is different from the first and for direct contact with connection electrodes (18, 20), wherein
the first active semiconductor layer (12) and the further active semiconductor layer (14) are arranged in a manner stacked one above another,
wherein the first and the further active semiconductor layer (12, 14) are fabricated separately from one another, **characterized in that** the first and the further active semiconductor layer (12, 14) are constructed in substrateless fashion without a carrier layer and are embodied as individual, separate semiconductor chips
- a first reflection layer (23) is arranged between the active semiconductor layers (12, 14), which reflection layer (23) is a layer of a transparent, electrically-conductive material,
- by means of the first reflection layer (23), a jump in the refractive index between the active semiconductor layers (12, 14) is divided into two smaller jumps,
- the first active semiconductor layer (12) has a radiation coupling-out area (26) and a second reflection layer (22) arranged on a side of the first active semiconductor layer (12) which is remote from the radiation coupling-out area (26), and
- the second reflection layer (22) is a metallic or dielectric layer.

2. Radiation-emitting device (40) according to Claim 1,
wherein the first active semiconductor layer (12) and/or the further active semiconductor layer (14) are/is mechanically fixedly and/or thermally coupled to a heat-dissipating layer (24).

3. Radiation-emitting device (40) according to either of the preceding claims,
wherein the second reflection layer (22) is thermally coupled to the heat-dissipating layer (24).

4. Radiation-emitting device (40) according to any of the preceding claims,
wherein the further active semiconductor layer (14) has a first radiation coupling-out area (28) and a further radiation coupling-out area (30) arranged on a side remote from the first radiation coupling-out area (21) of the further active semiconductor layer (14).

5. Radiation-emitting device (40) according to the preceding claim,
wherein one of the radiation coupling-out areas (28, 30) of the further active semiconductor layer (14) faces the radiation coupling-out area (26) of the first active semiconductor layer (12).

6. Radiation-emitting device (40) according to any of the preceding claims,
wherein the active semiconductor layer (12, 14) has a thickness (D) of between 3 µm and 20 µm.

7. Radiation-emitting device (40) according to any of the preceding claims,
wherein the active semiconductor layers (12, 14) stacked one above another together have a total thickness (D_T) of between 6 µm and 30 µm.

8. The radiation-emitting device (40) according to any of the preceding claims,
wherein the radiation-emitting device (40) is embodied in areal fashion and a radiation-emitting area region comprises an area of at least 10mm².

9. Radiation-emitting device (40) according to any of the preceding claims,
comprising the first active semiconductor layer (12) and at least two further active semiconductor layers (14), wherein at least one of the active semiconductor layers (12, 14) is embodied for the emission of electromagnetic radiation in the red spectral range, at least one of the active semiconductor layers (12, 14) is embodied for the emission of electromagnetic radiation in the green spectral range and at least one of the active semiconductor layers (12, 14) is embodied for the emission of electromagnetic radiation in the blue spectral range.

10. Use of a radiation-emitting device (40) according to any of the preceding claims for illumination purposes and/or for monochrome or multicolored electroluminescent displays and/or for projection applications.

## Revendications

1. Dispositif (40) émetteur de rayonnements, qui comporte
- une première couche active à semi-conducteur (12), qui est conçue pour émettre un rayonnement électromagnétique d'une première longueur d'onde et pour le contact direct avec des électrodes de raccordement (18, 20) et
- une couche active à semi-conducteur (14) supplémentaire, qui est conçue pour émettre un rayonnement électromagnétique dans une deuxième longueur d'onde différente de la première longueur d'onde et pour le contact direct avec des électrodes de raccordement (18, 20), la première couche active à semi-conducteur (12) et la couche active à semi-conducteur (14) supplémentaire étant placées en étant empilées l'une sur l'autre,
la première et la couche active supplémentaire à semi-conducteur (12, 14) étant fabriquées séparément l'une de l'autre,
**caractérisé en ce que**
- la première et la couche active supplémentaire à
semi-conducteur (12, 14) sont conçues sans substrat, sans couche porteuse et en tant que puce individuelle, séparée à semi-conducteur,
- entre les couches actives à semi-conducteur (12, 14) est placée une première couche de réflexion (23) qui est une couche d'une matière transparente, conductrice d'électricité,
- un saut dans l'indice de réfraction entre les couches actives à semi-conducteur (12, 14) est divisé en deux sauts plus petits par la première couche de réflexion (23),
- la première couche active à semi-conducteur (12) comporte une surface de découplage (26) du rayonnement et une deuxième couche de réflexion (22), placée sur le côté opposé à la surface de découplage (26) du rayonnement de la première couche active à semi-conducteur (12) et
- la deuxième couche de réflexion (22) est une couche métallique ou diélectrique.

2. Dispositif (40) émetteur de rayonnements selon la revendication 1,
la première couche active à semi-conducteur (12) et/ou la couche active à semi-conducteur (14) supplémentaire étant fixement accouplées mécaniquement et/ou thermiquement avec une couche (24) dissipant la chaleur.

3. Dispositif (40) émetteur de rayonnements selon l'une quelconque des revendications précédentes,
la deuxième couche de réflexion (22) étant thermiquement accouplée avec la couche (24) dissipant la chaleur.

4. Dispositif (40) émetteur de rayonnements selon l'une quelconque des revendications précédentes,
la couche active à semi-conducteur (14) supplémentaire comportant une première surface de découplage (28) du rayonnement et une surface supplémentaire de découplage (30) du rayonnement placée sur un côté opposé à la première surface de découplage (28) du rayonnement de la couche active à semi-conducteur (14) supplémentaire.

5. Dispositif (40) émetteur de rayonnements selon la revendication précédente,
l'une des surfaces de découplage (28, 30) du rayonnement de la couche active à semi-conducteur (14) supplémentaire faisant face à la surface de découplage (26) du rayonnement de la première couche active à semi-conducteur (12).

6. Dispositif (40) émetteur de rayonnements selon l'une quelconque des revendications précédentes,
la couche active de semi-conducteur (12, 14) ayant une épaisseur (D) comprise entre 3 µm et 20 µm.

7. Dispositif (40) émetteur de rayonnements selon l'une quelconque des revendications précédentes,
les couches actives à semi-conducteur (12, 14) empilées l'une sur l'autre ayant ensemble une épaisseur totale (D_T) comprise entre 6 µm et 30 µm.

8. Dispositif (40) émetteur de rayonnements selon l'une quelconque des revendications précédentes,
le dispositif (40) émetteur de rayonnements étant conçu en nappe et comportant une zone superficielle émettrice de rayonnements d'au moins 10 mm².

9. Dispositif (40) émetteur de rayonnements selon l'une quelconque des revendications précédentes,
avec la première couche active à semi-conducteur (12) et au moins deux couches actives à semi-conducteur (14) supplémentaires, au moins l'une des couches actives à semi-conducteur (12, 14) étant conçue pour émettre un rayonnement électromagnétique dans la plage spectrale rouge, au moins l'une des couches actives à semi-conducteur (12, 14) étant conçue pour émettre un rayonnement électromagnétique dans la plage spectrale verte et au moins l'une des couches actives à semi-conducteur (12, 14) étant conçue pour émettre un rayonnement électromagnétique dans la plage spectrale bleue.

10. Utilisation d'un dispositif (40) émetteur de rayonnements selon l'une quelconque des revendications précédentes à des fins d'éclairage et/ou pour des affichages électroluminescents monochromes ou multicolores et/ ou pour des applications en projection.
